(19) Europäisches Patentamt / European Patent Office / Office européen des brevets

(11) **EP 4 683 486 A1**

(12) **EUROPEAN PATENT APPLICATION**
published in accordance with Art. 153(4) EPC

(43) Date of publication:
**21.01.2026 Bulletin 2026/04**

(21) Application number: **24770438.0**

(22) Date of filing: **20.02.2024**

(51) International Patent Classification (IPC):
**H10N 30/853** (2023.01)　　**H10N 30/20** (2023.01)
**H10N 30/30** (2023.01)　　**H10N 30/50** (2023.01)

(52) Cooperative Patent Classification (CPC):
**H10N 30/877; H10N 30/076; H10N 30/704;
H10N 30/708; H10N 30/8554;** H10N 30/06

(86) International application number:
**PCT/JP2024/006073**

(87) International publication number:
**WO 2024/190325 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.03.2023 JP 2023040093**

(71) Applicant: FUJIFILM Corporation
**Tokyo 106-8620 (JP)**

(72) Inventors:
• **MOCHIZUKI, Fumihiko**
**Ashigarakami-gun, Kanagawa 258-8577 (JP)**
• **KOBAYASHI, Hiroyuki**
**Ashigarakami-gun, Kanagawa 258-8577 (JP)**
• **MUKAIYAMA, Akihiro**
**Ashigarakami-gun, Kanagawa 258-8577 (JP)**

(74) Representative: **Meissner Bolte Partnerschaft
mbB
Patentanwälte Rechtsanwälte
Postfach 86 06 24
81633 München (DE)**

(54) **PIEZOELECTRIC LAMINATE AND PIEZOELECTRIC ELEMENT**

(57)　Provided are a piezoelectric laminate and a piezoelectric element including, on a substrate in the following order: a lower electrode layer; and a piezoelectric film containing a perovskite-type oxide, in which the lower electrode layer includes an alloy layer containing Pt as a main component and one or more of Cu, Co, Ni, and Pd as an additive component, and in the alloy layer, an element ratio of the additive component to the main component is 10% to 40%, and in a case where the additive component includes Pd, an element ratio of Pd to the main component is 30% or less.

FIG. 1

EP 4 683 486 A1

**Description**

BACKGROUND OF THE INVENTION

1. Field of the Invention

The present disclosure relates to a piezoelectric laminate and a piezoelectric element.

2. Description of the Related Art

As a material having excellent piezoelectric characteristics and excellent ferroelectricity, there is known a perovskite-type oxide such as lead zirconate titanate ($Pb(Zr,Ti)O_3$, hereinafter referred to as PZT). A piezoelectric body consisting of a perovskite-type oxide is applied as a piezoelectric film in a piezoelectric element having a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and an oscillation power generation device.

In a case where the piezoelectric film is used for a memory, an actuator, a sensor, or the like, the configuration of the electrode is also important in addition to the piezoelectric characteristics of the piezoelectric film.

In the related art, an iridium (Ir) layer, a platinum (Pt) layer, or the like is used for an electrode. JP2006-253476A proposes that an alloy layer including at least one of Ir or Pt is provided as a lower electrode, and the alloy layer contains an additive metal having a melting point lower than a melting point of at least one of Ir or Pt.

SUMMARY OF THE INVENTION

JP2006-253476A describes that the lower electrode is formed of an alloy layer to suppress deterioration of piezoelectric characteristics due to oxygen loss from the piezoelectric film in a case where the lower electrode is formed of only a Pt layer and to suppress occurrence of cracks in a case where the lower electrode is formed of an Ir layer.

A high piezoelectric performance can be obtained in an electrode containing Ir, but Ir is extremely expensive, and the use of Ir makes it difficult to reduce the cost of the piezoelectric element. In addition, the present inventors have found that in a case where the lower electrode layer includes an alloy layer containing Pt, piezoelectric performance may be significantly deteriorated depending on the element species and the element ratio in the alloy layer.

The technology of the present disclosure has been made in view of the above circumstances, and an object of the present disclosure is to provide a piezoelectric laminate and a piezoelectric element, which include a piezoelectric film containing a perovskite-type oxide, and can realize high piezoelectric performance and cost reduction.

A piezoelectric laminate according to the present disclosure comprises, on a substrate in the following order:

a lower electrode layer; and
a piezoelectric film containing a perovskite-type oxide,
in which the lower electrode layer includes an alloy layer containing Pt as a main component and one or more of Cu, Co, Ni, and Pd as an additive component, and
in the alloy layer, an element ratio of the additive component to the main component is 10% to 40%, and in a case where the additive component includes Pd, an element ratio of Pd to the main component is 30% or less.

It is preferable that the lower electrode layer includes a Ti layer or a TiW layer as an adhesion layer between the alloy layer and the substrate.

It is preferable that the perovskite-type oxide contains Pb, Zr, Ti, and O. In this case, it is more preferable that the perovskite-type oxide contains Nb.

A piezoelectric element according to the present disclosure comprises:

the piezoelectric laminate according to the present disclosure; and
an upper electrode layer provided on the piezoelectric film of the piezoelectric laminate.

According to the technology of the present disclosure, it is possible to realize high piezoelectric performance and cost reduction in a piezoelectric laminate and a piezoelectric element, which include a piezoelectric film containing a perovskite-type oxide.

BRIEF DESCRIPTION OF THE DRAWINGS

Fig. 1 is a cross-sectional view showing a layer configuration of a piezoelectric laminate and a piezoelectric element, according to one embodiment.
Fig. 2 is a graph showing a relationship between an element ratio to a main component Pt and a piezoelectric constant of an additive component of an alloy layer.

DESCRIPTION OF THE PREFERRED EMBODIMENTS

Hereinafter, embodiments according to the present invention will be described with reference to the drawings. In the drawings below, a layer thickness of each of layers and a ratio thereof are appropriately changed and drawn for easy visibility, and thus they do not necessarily reflect the actual layer thickness and ratio. In the present specification, a numerical range expressed using "to" means a range that includes preceding and succeeding numerical values of "to" as a lower limit value and an upper limit value, respectively. In numerical ranges that are described stepwise in the present disclosure, an upper limit value or a lower limit value described in a certain numerical range may be replaced with an upper limit value or a lower limit value of another numerical range described stepwise. In addition, in a numerical range described in the present disclosure, an upper limit or a lower limit described in a certain numerical range may be replaced with a value described in Examples.

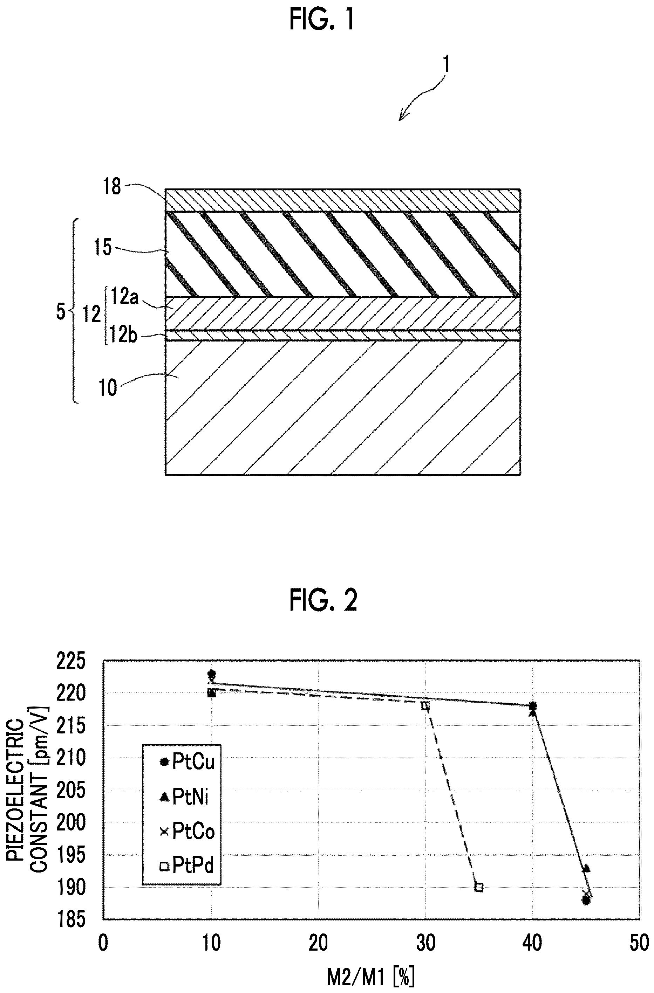

Fig. 1 is a schematic cross-sectional view showing a layer configuration of a piezoelectric laminate 5 and a piezoelectric element 1 having the piezoelectric laminate 5, according to an embodiment. As illustrated in Fig. 1, the piezoelectric element 1 has the piezoelectric laminate 5 and an upper electrode layer 18. The piezoelectric laminate 5 has a substrate 10, and a lower electrode layer 12 and a piezoelectric film 15 which are laminated on the substrate 10. Here, "lower" and "upper" do not respectively mean top and bottom in the vertical direction. As a result, an electrode disposed on the side of the substrate 10 with the piezoelectric film 15 being interposed is merely referred to as the lower electrode layer 12, and an electrode disposed on the side of the piezoelectric film 15 opposite to the substrate 10 is merely referred to as the upper electrode layer 18.

In the piezoelectric laminate 5, the piezoelectric film 15 contains a perovskite-type oxide, and particularly preferably a Pb-containing perovskite-type oxide. It is preferable that the piezoelectric film 15 is occupied by 80% by mole or more of the Pb-containing perovskite-type oxide. Further, it is preferable that the piezoelectric film 15 consists of a Pb-containing perovskite-type oxide (however, it contains unavoidable impurities).

The perovskite-type oxide is represented by General Formula $ABO_3$. A represents an A site element, B represents a B site element, and O represents an oxygen element, and A:B:O is 1:1:3 as a reference, but may deviate within a range in which a perovskite structure can be adopted.

The Pb-containing perovskite-type oxide is a perovskite-type oxide containing Pb as a main component of the A site. It is noted that in the present specification, "the main component" means a component of which the content is 50% by mole or more. That is, "containing Pb as a main component of the A site" means that among the A site elements, the component having 50% by mole or more is Pb. In the perovskite-type oxide containing Pb, the elements in the A site other than Pb and the elements of the B site are not particularly limited.

The A site element of the perovskite-type oxide may include one or two or more of barium (Ba), lanthanum (La), strontium (Sr), bismuth (Bi), lithium (Li), sodium (Na), calcium (Ca), cadmium (Cd), magnesium (Mg), and potassium (K), in addition to Pb.

The B site element B is one of titanium (Ti), zirconium (Zr), vanadium (V), niobium (Nb), tantalum (Ta), chromium (Cr), molybdenum (Mo), tungsten (W), manganese (Mn), iron (Fe), ruthenium (Ru), cobalt (Co), Ir, nickel (Ni), copper (Cu), zinc (Zn), gallium (Ga), indium (In), tin (Sn), antimony (Sb), or a lanthanide element, or a combination of two or more thereof.

The perovskite-type oxide is preferably a lead zirconate titanate (PZT) type that contains lead (Pb), zirconium (Zr), titanium (Ti), and oxygen (O).

In particular, it is preferable that the perovskite-type oxide is a compound represented by General Formula (P), which contains an additive B1 in the B site of PZT.

$$Pb\{(Zr_xTi_{1-x})_{1-y}B1_y\}O_3 \qquad (P)$$

Here, $0 < x < 1$ and $0 < y \leq 0.4$.

Examples of the B1 include scandium (Sc), V, Nb, Ta, Cr, Mo, W, Mn, Fe, Ru, Co, Ir, Ni, Cu, Zn, Ga, In, Sn, and Sb. It is preferable to contain one or more elements among these elements. B1 is more preferably any one of Sc, Nb, or Ni.

In particular, B1 is preferably Nb, and it is particularly preferably a compound represented by General Formula

(1).

$$Pb\{(Zr_xTi_{1-x})_{1-y}Nb_y\}O_3 \qquad (1)$$

$$0 < x < 1,\ 0.1 \le y \le 0.4$$

It is said that the PZT-based perovskite-type oxide exhibits high piezoelectric characteristics at the morphotropic phase boundary (MPB) and in the vicinity thereof. In the PZT system, the MPB is formed in the vicinity of Zr/Ti molar ratio = 55/45. In the above-described general formula, the MPB composition or a vicinity thereof is preferable. The "MPB or its vicinity" means a region in which a phase transition occurs in a case in which an electric field is applied to the piezoelectric film. Specifically, Zr:Ti (molar ratio) is in a range of 45:55 to 55:45, that is, x in General Formula (1) is preferably 45 to 55.

The film thickness of the piezoelectric film 15 is not particularly limited, and it is generally 200 nm or more, for example, 0.2 $\mu$m to 5 $\mu$m. The film thickness of the piezoelectric film 15 is preferably 1 $\mu$m or more.

The substrate 10 is not particularly limited, and examples thereof include substrates such as silicon, glass, stainless steel, yttrium-stabilized zirconia, alumina, sapphire, and silicon carbide. As the substrate 10, a laminated substrate having a $SiO_2$ oxide film formed on the surface of the silicon substrate may be used.

The lower electrode layer 12 is paired with the upper electrode layer 18 and is an electrode for applying a voltage to the piezoelectric film 15. The lower electrode layer 12 includes an alloy layer 12a containing Pt as a main component and containing one or more of Cu, Co, Ni, and Pd (palladium) as an additive component. The main component in the alloy layer 12a is a component indicating the maximum content of 50 at% or more among the components constituting the alloy layer 12a. In the alloy layer 12a, in a case where the element ratio of the additive component to the main component is 10% to 40% and the additive component includes Pd, the element ratio of Pd to the main component is 30% or less. The element ratio is synonymous with the molar ratio.

In a case where the element amount of Pt, which is the main component, is defined as M1 and the element amount of the additive component is defined as M2, the element ratio of the additive component to the main component is represented by M2/M1 [%]. In a case where the alloy layer 12a contains Cu, Co, or Ni individually as an additive component alone, the element ratio of the additive component to the main component is 10% to 40%, and in a case where Pd is contained as an additive component alone, the element ratio of the additive component to the main component is 10% to 30%. The additive component may be a combination of two or more of Cu, Co, Ni, and Pd, and in a case of Cu, Co, and Ni, the elements may be contained in any proportion as long as the element ratio with respect to the main component is in a range of 10% to 30%. On the other hand, in a case where the additive component includes Pd, the element ratio with respect to at least the main component of Pd is 30% or less. For example, in a case where the additive components are Pd and Cu, the element ratio with respect to the main component may be 10% to 40% as the total of both Pd and Cu, but the element ratio of Pd with respect to the main component is 30% or less.

The element ratio of the main component of the additive component to the main component is preferably 30% to 40% from the viewpoint of cost reduction, and is preferably 10% to 20% from the viewpoint of improving the conductivity.

It is preferable that the lower electrode layer 12 includes an adhesion layer 12b between the substrate 10 and the alloy layer 12a. As the adhesion layer 12b, a Ti layer, a TiW layer, or the like is preferable. By providing the adhesion layer 12b, peeling between the lower electrode layer 12 and the substrate 10 can be suppressed.

The lower electrode layer 12 may further comprise a conductive perovskite-type oxide layer between the alloy layer 12a and the piezoelectric film 15. Examples of the conductive perovskite-type oxide layer include indium tin oxide (ITO), $LaNiO_3$, and $SrRuO_3$ (SRO).

A layer thickness of the lower electrode layer 12 is not particularly limited, and is preferably about 50 nm to 300 nm and more preferably 100 nm to 300 nm as a whole.

The upper electrode layer 18 is paired with the lower electrode layer 12 and is an electrode for applying a voltage to the piezoelectric film 15. The main component of the upper electrode layer 18 is not particularly limited, and examples thereof include metals such as gold (Au), Pt, Ir, Ru, Ti, Mo, Ta, and Al or metal oxides thereof, and combinations thereof. In addition, indium tin oxide (ITO), $LaNiO_3$, SRO, or the like may be used. The upper electrode layer 18 may be a single layer or may have a laminated structure composed of a plurality of layers. It is noted that from the viewpoint of further suppressing oxygen diffusion from the piezoelectric film 15, at least a region of the upper electrode layer 18, which is in contact with the piezoelectric film 15, is preferably an oxide electrode.

The layer thickness of the upper electrode layer 18 is not particularly limited, and it is preferably about 50 nm to 300 nm and more preferably 100 nm to 300 nm.

The piezoelectric element 1 as described above can be produced by forming each layer of the lower electrode layer 12, the piezoelectric film 15, and the upper electrode layer 18 on the substrate 10, for example, by a sputtering method.

As described above, the piezoelectric laminate 5 and the piezoelectric element 1 of the present embodiment comprise the alloy layer 12a containing Pt as a main component and containing one or more of Cu, Co, Ni, and Pd as an additive component in the lower electrode layer 12, in which the alloy layer 12a has an element ratio of 10% to 40% to the main component of the additive component, and in a case where the additive component contains Pd, the element ratio of Pd to the main component of Pd is 30% or less. By providing such a lower electrode layer 12, it is possible to realize high piezoelectric performance equivalent to a case where an Ir layer is provided in the lower electrode layer in the related art, and it is possible to realize cost reduction since Ir is not used.

It is known that in a case where a piezoelectric film is formed by sputtering at a high temperature of 600°C or higher, a metal component in the piezoelectric film consisting of a perovskite-type oxide easily diffuses into the lower electrode layer. The Ir layer used in the lower electrode layer in the related art has a high barrier function, suppresses the diffusion of the metal component in the piezoelectric film, and can suppress the deterioration of the piezoelectric performance of the piezoelectric film formed on the Ir layer. Similarly, the Pt layer used in the related art for the lower electrode layer has a low function of suppressing the diffusion of the metal component in the piezoelectric film, and there is a problem that peeling is likely to occur. However, as in the present embodiment, by including an alloy layer containing Pt as a main component and one or more of Cu, Co, Ni, and Pd as an additive component, in a case where the piezoelectric film 15 is formed on the upper layer by sputter film formation at a high temperature of 600°C or higher, diffusion of the metal in the piezoelectric film can be suppressed, and a remarkable effect of suppressing peeling can be obtained.

The piezoelectric element 1 or the piezoelectric laminate 5 according to each of the above embodiments can be applied to an ultrasonic device, a mirror device, a sensor, a memory, and the like.

Examples

Hereinafter, specific examples and comparative examples of the piezoelectric element according to the present disclosure will be described. First, a production method for a piezoelectric element of each example will be described. A radio frequency (RF) sputtering device was used for the deposition of each layer. The description of the manufacturing method will be made with reference to the reference numerals of the respective layers of the piezoelectric element 1 illustrated in Fig. 1.

(Production method)

- Substrate -

As the substrate 10, a thermal oxide film-attached silicon substrate was used.

- Lower electrode layer -

TiW was formed into a film of 20 nm as the adhesion layer 12b of the lower electrode layer 12 on the thermal oxide film of the substrate 10. Thereafter, an alloy layer 12a was formed to a thickness of 150 nm on the TiW layer, the alloy containing Ir as a first component (corresponding to the main component of the present disclosure). The element ratio M2/M1 [%] of the second component M2 to the first component M1 of the alloy layer 12a in each of Examples and Comparative Examples was as shown in Table 1. In Comparative Example 1, an Ir layer was used instead of the alloy layer 12a, and in Comparative Example 2, a Pt layer was used instead of the alloy layer 12a. In a case of forming the alloy layer, co-sputtering using a Pt target and a metal target to be added was carried out. The ratio between Pt and the additive component was adjusted by adjusting the target input power.

- Piezoelectric film -

A PZT film doped with Nb, having a thickness of substantially 2 $\mu$m was, formed as the piezoelectric film 15 on the lower electrode layer 12 with a radio frequency (RF) sputtering. A PZT target doped with Nb was used. A target was used in which a Pb composition ratio = 1.3, a Zr/Ti molar ratio is an MPB composition (Zr/Ti = 52/48), that is, x = 0.52, and a Nb composition ratio y = 0.12. A substrate setting temperature during film formation was set to 615°C.

- Sputtering conditions for piezoelectric film -

Distance between target and substrate: 60 mm

Power input to target: 500 W
Vacuum degree: 0.3 Pa, an Ar/$O_2$-mixed atmosphere ($O_2$ volume fraction: 10%)
Substrate set temperature: 615°C

- Upper electrode layer -

An ITO layer was formed on the piezoelectric film 15 of the above-described laminated substrate as an upper electrode layer 18 having a thickness of 100 nm by sputtering.

<Measurement of piezoelectric constant>

(Preparation of measurement sample)

A cantilever was produced by cutting out a striped portion of 2 mm × 25 mm from a laminated substrate produced by laminating the respective layers on the above-described substrate 10.

(Measurement)

According to the method described in I. Kanno et. al. Sensor and Actuator A 107 (2003) 68, by using a cantilever, the piezoelectric constant $d_{31}$ [pm/V] was measured using an applied voltage obtained by adding a sine wave with an amplitude of 10 V to an applied voltage of a sine wave of -10 V ± 10 V, that is, a bias voltage of -10 V. The measurement results are shown in Table 1.

[Table 1]

|  | | Alloy layer component M1M2 | M2/M1(%) | Piezoelectric constant $d_{31}$ [pm/V] |
|---|---|---|---|---|
|  | Example 1 | PtCu | 10 | 223 |
|  | Example 2 | PtCu | 40 | 218 |
|  | Example 3 | PtNi | 10 | 220 |
|  | Example 4 | PtNi | 40 | 217 |
|  | Example 5 | PtCo | 10 | 222 |
|  | Example 6 | PtCo | 40 | 218 |
|  | Example 7 | PtPd | 10 | 220 |
|  | Example 8 | PtPd | 30 | 218 |
| Comparative Example 1 | | Ir | 0 | 224 |
| Comparative Example 2 | | Pt | 0 | Measurement unavailable (peeling) |
| Comparative Example 3 | | PtCu | 45 | 188 |
| Comparative Example 4 | | PtNi | 45 | 193 |
| Comparative Example 5 | | PtCo | 45 | 189 |
| Comparative Example 6 | | PtPd | 35 | 190 |

Comparative Example 1 comprises an Ir layer instead of the alloy layer 12a. In a case where the Ir layer is provided, the piezoelectric constant is the highest. However, as described in the section of the related art, since Ir is extremely expensive, it is difficult to reduce the cost of the piezoelectric element. In Comparative Example 2 in which the Pt layer was provided instead of the alloy layer 12a, peeling occurred, and the piezoelectric element did not function. In a case where the Pt layer is used, it is considered that diffusion of a metal occurs from the piezoelectric film provided in the upper layer to the lower electrode side, Pb is precipitated at the interface with the Pt layer, and as a result, peeling occurs.
Examples 1 to 8 all exhibited a piezoelectric constant $d_{31}$ substantially equivalent to that of Comparative Example 1 and had favorable piezoelectric characteristics. Here, the term "equivalent" means that the difference from the piezoelectric constant $d_{31}$ of Comparative Example 1 is within 5%. On the other hand, since Ir is not used, the cost of the piezoelectric element can be reduced. On the other hand, in Comparative Examples 3 to 6, the lower electrode layer includes an alloy layer, but in Comparative Examples 3 to 5 in which the additive components were Cu, Ni, and Co, the element ratiois 45% which was more than 40%, and in Comparative Example 6 in which the additive component is Pd, the element ratio is 35% which was more than 30%. In any of Comparative Examples, the piezoelectric constant $d_{31}$ was significantly low as compared with Examples.

From each of Examples and Comparative Examples, the change in the piezoelectric constant $d_{31}$ [pm/V] with respect to the element ratio M2/M1 [%] of the second component to the first component of the second component of each kind of the second component of the alloy layer is summarized in Table 2 and Fig. 2. In Table 2, the first row is the element ratio M2/M1 [%], the first column shows the components of the alloy layer, and the second row and second column and subsequent rows show the piezoelectric constant $d_{31}$ [pm/V] in each alloy layer and each element ratio. Fig. 2 is a graph in which Table 2 is graphed, and the horizontal axis represents the element ratio M2/M1 [%] and the vertical axis represents the piezoelectric constant $d_{31}$ [pm/V].

[Table 2]

|      | 10  | 30  | 35  | 40  | 45  |
|------|-----|-----|-----|-----|-----|
| PtCu | 223 | -   | -   | 218 | 188 |
| PtNi | 220 | -   | -   | 217 | 193 |
| PtCo | 222 | -   | -   | 218 | 189 |
| PtPd | 220 | 218 | 190 | -   | -   |

As shown in Table 2 and Fig. 2, in a case where the second component is Cu, Ni, or Co, the piezoelectric constant exhibits a value of within 5% of that of Comparative Example 1 in a case where the element ratio of the second component to the first component is in a range of 10% to 40%, and the piezoelectric constant is significantly decreased in a case where the element ratio is 45%. In addition, in a case where the second component is Pd, the piezoelectric constant is a value within 5% of Comparative Example 1 in a case where the element ratio of the second component to the first component is in a range of 10% to 30%, and the piezoelectric constant is significantly decreased in a case where the element ratio is 35%.

Here, a configuration in which any one of Cu, Ni, Co, or Pd is included as the second component has been described, but it is presumed that the same results can be obtained even in a case where two or more of Cu, Ni, Co, and Pd are combined and included as the second component. That is, it is considered that in a case where the second component is a combination of two or more of Cu, Ni, and Co, and the total element ratio thereof with respect to the first component is 10% to 40%, good piezoelectric performance is exhibited. On the other hand, in a case where the second component contains Pd, it is considered that the element ratio of Pd itself is 30% or less, and in a case where the second component contains Cu, Ni, or Co in addition to Pd and the total element ratio thereof with respect to the first component is 40% or less, good piezoelectric performance is exhibited.

In regard to the above-described embodiment, the supplementary notes will be further disclosed as follows.

(Supplementary Note 1)

A piezoelectric laminate comprising, on a substrate in the following order:

a lower electrode layer; and
a piezoelectric film containing a perovskite-type oxide,
in which the lower electrode layer includes an alloy layer containing Pt as a main component and one or more of Cu, Co, Ni, and Pd as an additive component, and
in the alloy layer, an element ratio of the additive component to the main component is 10% to 40%, and in a case where the additive component includes Pd, an element ratio of Pd to the main component is 30% or less.

(Supplementary Note 2)

The piezoelectric laminate according to Supplementary Note 1,
wherein the lower electrode layer includes a Ti layer or a TiW layer as an adhesion layer between the alloy layer and the substrate.

(Supplementary Note 3)

The piezoelectric laminate according to Supplementary Note 1 or 2, in which the perovskite-type oxide contains Pb, Zr, Ti, and O.

(Supplementary Note 4)

The piezoelectric laminate according to Supplementary Note 3, in which the perovskite-type oxide contains Nb.

(Supplementary Note 5)

A piezoelectric element comprising:
the piezoelectric laminate according to any one of Supplementary Notes 1 to 4; and
an upper electrode layer provided on the piezoelectric film of the piezoelectric laminate.
The disclosure of Japanese Patent Application No. 2023-040093 filed on March 14, 2023 is incorporated in the present specification by reference. All of the documents, the patent applications, and the technical standards described in the present specification are incorporated into the present specification by reference to the same extent as in a case in which each of the documents, the patent applications, and the technical standards are specifically and individually stated to be described by reference.

Explanation of References

1: piezoelectric element
5: piezoelectric laminate
10: substrate
12: lower electrode layer
12a: alloy layer
12b: adhesion layer
15: piezoelectric film
18: upper electrode layer

**Claims**

1.  A piezoelectric laminate comprising, on a substrate in the following order:

    a lower electrode layer; and
    a piezoelectric film containing a perovskite-type oxide,
    wherein the lower electrode layer includes an alloy layer containing Pt as a main component and one or more of Cu, Co, Ni, and Pd as an additive component, and
    in the alloy layer, an element ratio of the additive component to the main component is 10% to 40%, and in a case where the additive component includes Pd, an element ratio of Pd to the main component is 30% or less.

2.  The piezoelectric laminate according to claim 1,
    wherein the lower electrode layer includes a Ti layer or a TiW layer as an adhesion layer between the alloy layer and the substrate.

3.  The piezoelectric laminate according to claim 1,
    wherein the perovskite-type oxide contains Pb, Zr, Ti, and O.

4.  The piezoelectric laminate according to claim 3,
    wherein the perovskite-type oxide contains Nb.

5.  A piezoelectric element comprising:

    the piezoelectric laminate according to any one of claims 1 to 4; and
    an upper electrode layer provided on the piezoelectric film of the piezoelectric laminate.

# FIG. 1

# FIG. 2

## INTERNATIONAL SEARCH REPORT

| International application No. |
|---|
| **PCT/JP2024/006073** |

| A. | CLASSIFICATION OF SUBJECT MATTER |
|---|---|

*H10N 30/853*(2023.01)i; *H10N 30/20*(2023.01)i; *H10N 30/30*(2023.01)i; *H10N 30/50*(2023.01)i
FI:   H10N30/853; H10N30/20; H10N30/30; H10N30/50

According to International Patent Classification (IPC) or to both national classification and IPC

| B. | FIELDS SEARCHED |
|---|---|

Minimum documentation searched (classification system followed by classification symbols)

H10N30/853; H10N30/20; H10N30/30; H10N30/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 11-284244 A (KYOCERA CORPORATION) 15 October 1999 (1999-10-15) paragraphs [0006], [0015]-[0019], [0022], [0044], [0047], fig. 1, table 4, examples 16-18 | 1, 3-5 |
| Y | | 2 |
| Y | JP 2004-235599 A (MATSUSHITA ELECTRIC INDUSTRIAL CO., LTD.) 19 August 2004 (2004-08-19) paragraphs [0016], [0091]-[0098], fig. 1 | 2 |
| A | | 1, 3-5 |
| A | JP 2006-253476 A (SEIKO EPSON CORPORATION) 21 September 2006 (2006-09-21) entire text, all drawings | 1-5 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 May 2024** | **14 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/006073**

| Patent document cited in search report | | | Publication date (day/month/year) | Patent family member(s) | Publication date (day/month/year) |
|---|---|---|---|---|---|
| JP | 11-284244 | A | 15 October 1999 | (Family: none) | |
| JP | 2004-235599 | A | 19 August 2004 | US 2003/0222947 A1<br>paragraphs [0017], [0097]-[0104], fig. 1<br>US 2005/0280335 A1<br>CN 1461703 A | |
| JP | 2006-253476 | A | 21 September 2006 | (Family: none) | |

Form PCT/ISA/210 (patent family annex) (July 2022)

**EP 4 683 486 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006253476 A

- JP 2023040093 A